Europäisches Patentamt

**European Patent Office**

**Office européen des brevets**

(11) Publication number: **0 413 347 A2**

# EUROPEAN PATENT APPLICATION

(21) Application number: **90115797.4**

(51) Int. Cl.⁵: **G11C 16/06**

(22) Date of filing: **17.08.90**

(30) Priority: **18.08.89 JP 211321/89**

(43) Date of publication of application:
**20.02.91 Bulletin 91/08**

(84) Designated Contracting States:
**DE FR GB IT**

(71) Applicant: **HITACHI, LTD.**
**6, Kanda Surugadai 4-chome**
**Chiyoda-ku, Tokyo 100(JP)**

(72) Inventor: **Seki, Koichi**
**2-11-10, Hirayama**
**Hino-shi, Tokyo, 191(JP)**

Inventor: **Wada, Takeshi**
**2-27-23-803, Tsutsujigaoka**
**Akishima-shi, Tokyo, 196(JP)**
Inventor: **Muto, Tadashi**
**2813-6, Miyadera**
**Iruma-shi, Saitama, 358(JP)**
Inventor: **Izawa, Kazuo**
**2-5-5, Sakai**
**Musashino-shi, Tokyo, 180(JP)**

(74) Representative: **Strehl, Schübel-Hopf,**
**Groening**
**Maximilianstrasse 54 Postfach 22 14 55**
**D-8000 München 22(DE)**

(54) **Semiconductor nonvolatile memory device.**

(57) An electrically erasable semiconductor memory device is disclosed which makes it possible to detect the presence of the memory cell whose threshold voltage becomes negative after erase operation. The information stored in the memory cells are read while all gates of the memory cells are kept on the voltage to make them nonselective in order to easily and quickly detect the memory cell whose threshold voltage is negative.

FIG. 7

## SEMICONDUCTOR NONVOLATILE MEMORY DEVICE

Background of the Invention

The present invention relates to a semiconductor nonvolatile memory device and an information processing system employing such a memory device, and in particular to a batch erasable type EEPROM (electrically erasable and programmable read only memory) which is easily depletion tested, and also to a microcomputer system employing such an EEPROM.

As a semiconductor nonvolatile memory device, there are known an erasable programmable read-only memory (referred to as an "EPROM") the stored information of which is erasable by utilizing ultraviolet radiation, and also an electrically erasable and programmable read-only memory (referred to as an "EEPROM") the stored information of which is electrically erasable. An EPROM is suitable for a large-scale memory capacity because areas of memory cells for storing information are relatively small. However, to erase the information stored in an EPROM, it is necessary to irradiate ultraviolet rays to the memory cells. To this end, a package having an ultraviolet irradiating window, which is relatively expensive, would be required in order to be able to employ such type of memory cells. Moreover, in order to be able to write or rewrite new information by a programmer, the EPROM must be removed from the system to which this EPROM has been actually packaged in, thereby resulting in a problem.

On the other hand, with respect to an EEPROM, the information stored therein is electrically erasable and writable, while the EEPROM remains packaged in a system. However, areas associated with memory cells of the EEPROM type are relatively large. For instance, a typical area of a memory cell in an EEPROM is approximately 2.5 to 5 times larger than that of an EPROM. As a result, in general, an EEPROM is not suitable when emphasis is in having a large memory capacity. A semiconductor nonvolatile memory device that can be considered as being between or intermediate the EPROM and EEPROM, which is so-called "electrically batch erasable type EEPROM", has very recently been developed. This electrically batch erasable type EEPROM is also called "a flash EEPROM", and is a semiconductor nonvolatile memory device in which either all of the memory cells formed in a chip, or the entirety of a certain memory cell group among the memory cells formed in the chip are electrically erased. In accordance with the flash EEPROM, the size of a memory cell thereof can be formed to be substantially the same as that of EPROM. Such a flash EEPROM is described in, for instance, IEEE INTERNATIONAL SOLID-STATE CIRCUIT CONFERENCE in 1980, on pages 152 to 153; IEEE INTERNATIONAL SOLID-STATE CIRCUIT CONFERENCE in 1987, on pages 76 to 77; and IEEE, J. SOLID-STATE CIRCUITS, vol. 23 (1988), pages 1157 to 1163.

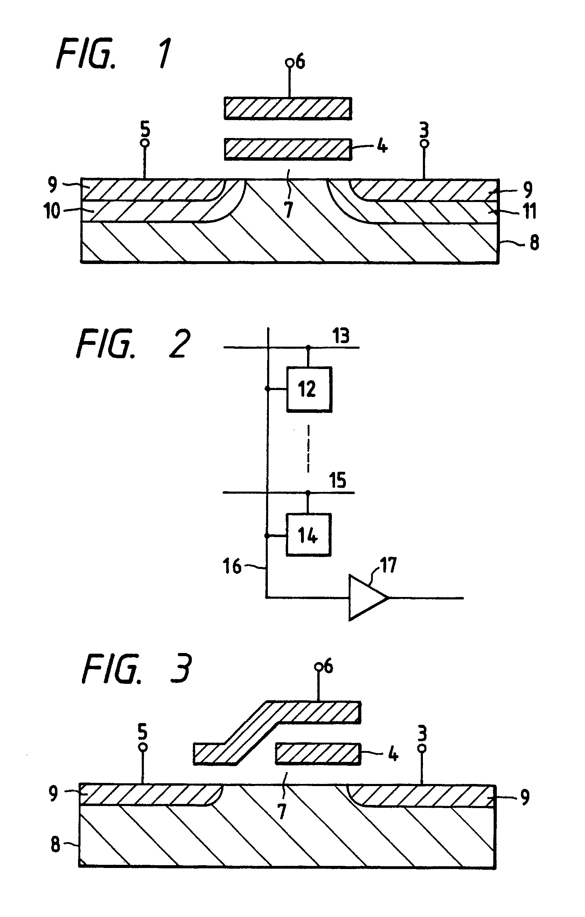

In Fig. 1, there is represented a schematic sectional view of the flash EEPROM, which has been disclosed during the International Electron Device Meeting held in 1987. The memory cell shown in Fig. 1 is very similar to the memory cell of the normal EPROM. That is to say, this memory cell is constructed in accordance with an insulated gate type field-effect transistor (simply referred to as a "MOSFET" or "transistor"). However, it has a double layer gate structure. In the structure of Fig. 1, reference numeral 8 indicates a P type silicon substrate; reference numeral 11 denotes a P type diffusion layer formed on the silicon substrate 8; reference numeral 10 represents an N type diffusion layer having a low concentration formed on the silicon substrate 8; and reference numeral 9 indicates an N type diffusion layer formed on each of the P type diffusion layer 11 and N type diffusion layer 10. Also, reference numeral 4 represents a floating gate formed on the P type silicon substrate 8 via a thin oxide film 7. Reference numeral 6 denotes a control gate formed on this floating gate 4 via the oxide film; reference numeral 3 indicates a drain electrode; and reference numeral 5 represents a source electrode. In other words, the memory cell shown in Fig. 1 is constructed like a MOSFET but has an N-channel type double gate structure. Thus, the information is stored in this transistor, and is held in this transistor in accordance with effecting a change of the threshold voltage thereof.

It should be noted that a transistor (referred to as a "storage transistor") of a memory cell, for storing information, discussed herein is of an N-channel storage transistor unless stated otherwise in the following description.

The information writing operation with respect to the memory cell represented in Fig. 1 is similar to that of EPROM. In other words, the writing operation of the EEPROM shown in Fig. 1 is performed by injecting into the floating gate 4 a hot carrier produced adjacent to the drain region 9 connected to the drain electrode 3. The threshold voltage of the storage transistor with respect to the control gate 6 is higher than that of another storage transistor which does not perform the writing operation, while such a writing operation is carried out.

In the erasing operation, on the other hand, the control gate 6 is grounded, and the high voltage is applied to the source electrode 5, whereby a high electric field is produced between the floating gate 4 and the source region 9 connected to the source electrode 5. Then, while utilizing the tunneling phenomenon via the thin oxide film 7, electrons which have been stored in the floating gate 4 are drawn, via the source region 9, to the source electrode. As a result, the stored information disappears. In other words, the threshold voltage of the storage transistor is lowered with respect to the control gate 6.

During a reading operation, in order to prevent a weak writing operation from being undesirably effected to the above-described memory cell, that is, to prevent undesired carriers from being injected into the floating gate, the voltages applied to both the drain electrode 3 and control gate 6 are limited to a relatively low value. A low voltage of, for instance, on the order of 1 volt is applied to the drain electrode 3, and a voltage on the order of 5 volts is applied to the control gate 6. A magnitude of a channel current flowing through the storage transistor is detected in accordance with such applied voltages so as to determine whether or not the information stored in the memory cell corresponds to "0" or "1".

In general, during the electrical erasing operation, when the erasing operation is continued for a long time, the threshold voltage of the storage transistor will become different from that of a storage transistor under the thermal balance, namely it may become a negative value. This is in contrast to the EPROM where the stored information is erased by way of ultraviolet radiation, the threshold voltage of the storage transistor which is varied in accordance with the erasing operation is substantially equal to the threshold voltage which is obtained when this memory device is manufactured. In other words, the threshold voltage of the storage transistor after the erasing operation may be controlled by the manufacturing conditions and the like of this memory device. However, as previously described, in the case that the stored information is electrically erased, the stored information disappears when the electrons stored in the floating gate are drawn to the source electrode. As a consequence, if the erasing operation in connection with such an EEPROM as in Fig. 1 is continued for a relatively long time, a large quantity of electrons are drawn away from the floating gate into the source electrons which have been injected into the floating gate while the writing operation is carried out. Therefore, when the electrical disappearance or erasing of the stored information is continued for a relatively long time, the threshold voltage of the storage transistor attains a different value from the threshold voltage obtained when the memory device is manufactured. That is to say, after the erasing operation is performed, the threshold voltage of the storage transistor might no longer be equal to the threshold voltage determined by the manufacturing conditions thereof, in contrast to the EPROM.

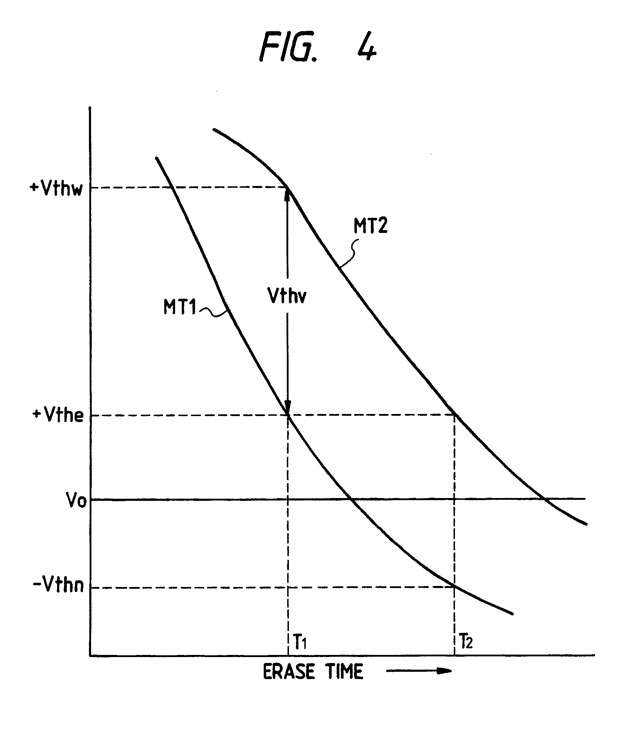

The Applicants, in accordance with their investigative and research efforts, have measured the variations in the threshold voltage of the storage transistor caused by the electrical erasing operation. In Fig. 4, there is shown a relationship, based on such measured variations, between the threshold voltage of the storage transistors MT1, MT2 as varied by the length of time of the erasing operation. In Fig. 4, graph MT1 shows the erase characteristics of the memory transistor which is fastest in erasure in the chip, graph MT2 shows that of the memory transistor which is slowest in erasure in the chip. In the graphic representation shown in Fig. 4, the abscissa denotes the erase time, whereas the ordinate indicates the threshold voltage of the storage transistor. "$V_o$" indicates that the threshold voltage is substantially equal to zero, "$+V_{the}$" represents that the threshold voltage is equal to a positive voltage; and "$-V_{thn}$" indicates that the threshold voltage is equal to a negative voltage. Also, "$V_{thv}$" represents a range of fluctuation in the threshold voltage among memory transistors, which is caused by fluctuations and the like of the manufacturing conditions. From this figure, it should be understood that if the erasing operation is continued for a relatively long time, the threshold voltage with respect to an N-channel storage transistor, for example, is changed wherein it becomes a negative voltage. Similarly, it should be understood from this figure that different threshold voltage of the respective storage transistors may result from an erasing operation because of fluctuations in the manufacturing conditions. That is, memory transistor MT1 has the positive low threshold voltage $+V_{the}$ at $T_1$, which means that the erase of MT1 is finished. But memory transistor MT2 still has the positive high threshold voltage $+V_{thw}$ at $T_1$, which means that the erase of MT2 is not finished.

When the erase of MT2 is finished at T2, MT1 has the negative threshold voltage $-V_{thn}$. This shows the problem existing, namely that two transistors may have different "erase characteristics" requiring extra erase time (such as MT2) that results in MT1 having a negative threshold voltage.

As previously described, when the threshold value of the storage transistor becomes negative, the readout operation becomes adversely influenced. This adverse influence will now be described with reference to Fig. 2. It is now assumed that the information stored in the memory cell 12 is read out. Reference numeral 17 shown in Fig. 2 indicates a sense amplifier. To bring the memory cell 12 into the selective condition, the selective voltage of the readout operation, for instance the power source voltage $V_{cc}$(5V), is applied to the word line 13 connected to the memory cell 12. During this time, the non-selection voltage of the readout operation, for example the ground voltage OV, is supplied to the word lines 15 etc. in order to bring the other memory cells 14 etc. into the non-selective condition. If the memory cell 14, which is in the non-selective condition and is connected to the data line 16 as well as the memory cell 12 from which the stored information is to be read out, has the negative threshold voltage, an undesired current (non-selective leak current) flows through the data line 16 via the memory cell 14 which has been brought into the non-selective condition, even if the voltage of the word line 15, namely the voltage of the control gate of the memory cell, becomes zero. The non-selective current may cause a delay in a readout time and thus an erroneous reading operation may be induced.

Similarly, there is an adverse influence with respect to a writing operation if the storage transistor within the memory cell has the negative threshold voltage. Normally, in the case where the writing operation is performed by utilizing hot carrier transfer, the high voltage ($V_{pp}$) employed for the writing operation, which is externally applied, is applied via a switching MOSFET to the drain region of the storage transistor within the memory cell. The voltage drop in the above-described MOSFET is changed, depending upon the current flowing therethrough. As a consequence, under such a condition that the threshold voltage of the storage transistor becomes negative, the above-described voltage drop across the MOSFET becomes too large so that the voltage applied to the drain of the storage transistor within the memory cell is lowered by the above-described voltage drop. As a result, the time required for the writing operation may be increased.

Consequently, in the above described EEPROM, a precise control must be implemented in order to control the value of the threshold value after the erasing operation.

In order to effect the electrical erasing operation of the stored information in a conventional EEPROM, for instance, as described in IEEE International Solid-State Circuit Conference on pages 152 to 153 in 1980, each memory cell therein includes a storage transistor and selective transistor for blocking the non-selective leak current. Also, in this EEPROM, the program line is coupled to the control gate of the storage transistor thereof, whereas the selective line is coupled to the gate of the selective transistor. That is to say, the storage transistor and the selective transistor of each memory cell thereof are coupled to independent lines, respectively.

In Fig. 3, there is shown a sectional view of the memory cell of the electrical batch erasing type EEPROM which has been described on pages 76 to 77 in IEEE International Solid-State Circuit Conference in 1987. In Fig. 3, reference numeral 8 indicates a P type silicon substrate; 9 indicates N type diffusion layers formed on the silicon substrate 8. Also, reference numeral 4 represents a floating gate formed on the silicon substrate 8 via a thin oxide film 7. Reference numeral 6 denotes a control gate formed on this floating gate 4 and silicon substrate 8 via the oxide film; reference numerals 3 and 5 indicate drain and source electrode, respectively. Although the operation of this memory cell is substantially the same as that of the memory cell shown in Fig. 1, the erasing operation of the stored information is different from that of the memory cell shown in Fig. 1. That is to say, the erasing operation of this EEPROM is carried out by utilizing the tunneling phenomenon effected between the floating gate and drain region. In this memory cell, though there is only one gate electrode to be connected to the word line, substantially two transistors are used to construct the memory cell. In other words, it can be assumed that the memory cell is arranged by the selective transistor and storage transistor in which both the gate electrode and control gate electrode are formed on a body. As previously described, since this memory cell essentially includes the selective transistor, the conventional problem of the non-selective leak current occurring during the readout time has been solved. However, since the writing operation is performed by the hot carrier required for a larger quantity of current, as compared with the writing operation effected by utilizing the tunneling phenomenon, the problem of the above-described adverse influences upon the writing operation are still present.

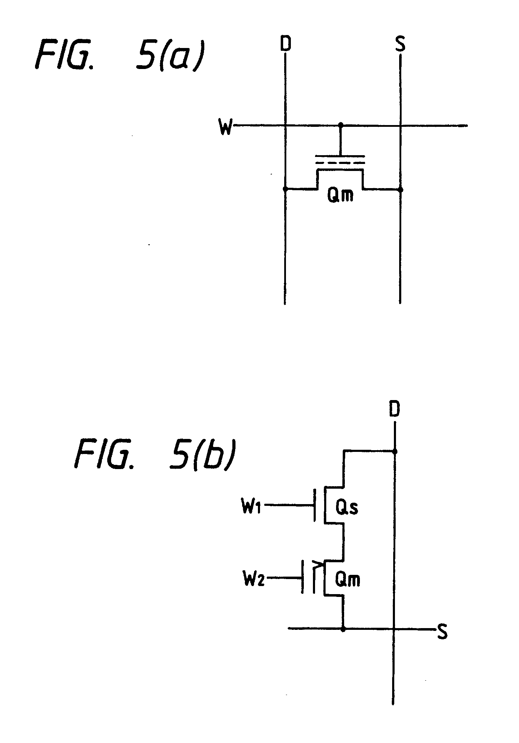

In the conventional EEPROM as described in, for instance, IEEE International Solid-State Circuit Conference, on pages 152 to 153 in 1980, a single memory cell is constructed of a storage transistor and a selective transistor which are connected to respectively different word lines. However, in the memory cell of another type of EEPROM, such as of the electrically batch erasing type of EEPROM as represented in Figs. 1 and 3, it is constructed of a single storage transistor connected to a single word line. Such a specific arrangement as may be apparent in connection with the memory cells and the like shown in Figs. 1 and 3 are herein represented by circuit diagrams. To this end, the representative circuit diagrams of the above-described memory cell are illustrated in Figs. 5a and 5b. Fig. 5b shows a circuit diagram of the memory cell which was announced at the IEEE International Solid-State Circuit Conference held in 1980. In the memory cell shown in Fig. 5b, symbols "$W_1$" and "$W_2$" denote different word lines, and symbol "D" represents a data line. Also, symbol "$Q_s$" indicates a selective transistor whereas symbol "$Q_m$" represents a storage transistor. Fig. 5a shows a circuit diagram of the memory cell shown in Figs. 1 and 3. As is apparent from this circuit diagram, a single memory cell is so constructed that a control gate of a single storage transistor $Q_m$ is connected to a single word line, a drain thereof is connected to a single data line "D," and a source thereof is connected to a single source line "S". In order to select a desired single memory cell from a plurality of memory cells of the type according to Fig. 5a while performing the reading/writing operations, only a single word line and a single data line are required to be selected. This cell which is selected, of course, corresponds to the selected work line "W" and to the selected data line "D". In other words, a single memory cell can be defined by one word line and one data line. It should be noted that in Fig. 5a, the source line "S" is commonly used as the source lines "S" of all of the remaining storage transistors formed on the chip. alternatively, each source line "S" provided can be commonly used with respect to a predetermined number of memory cells constituting a single memory block.

Since the memory cell shown in Fig. 5a can be arranged with a single storage transistor, the area on the chip required for forming the memory cell can be reduced to a small area substantially equal to that of an EPROM. However, in order to realize the electrically batch erasing operation of the stored information, as described above, it is necessary to be capable of controlling the threshold voltage of the storage transistor after the erasing operation.

To this end, according to prior efforts, the erasing operation is subdivided into a certain number of erasing operations. Then, a confirmation determination is made as to whether or not the erasing operation is sufficient. If the erasing operation performed is determined to be insufficient or inadequate, the erasing operation is again repeated. In accordance with the above-described IEEE, J. Solid-State Circuits vol. 23 (1988), pages 1157 to 1163, there is proposed an algorithm relating to a control of the threshold voltage after such an erasing operation. In accordance with this publication, this algorithm is executed by the microprocessor which is provided separately with the electrically batch erasing type EEPROM. Also, in order to maintain the lower limit voltage "Vcc min" of the operable power source during the normal read out operation, a description given therein requires that the verify voltage be generated in the chip of the EEPROM while in the reading operation in the above-described algorithm (erasing verify operation).

The threshold voltages of memory transistors in the chip may become unequal and varied from each other when the contents of the plurality of memory cells are simultaneously erased. In the algorithm stated above, the erasure operation is stopped when the threshold voltage of the memory transistor which is slowest in erasure becomes lower than a predetermined voltage. At this time, the threshold voltage of the fastest memory transistor is lower than that predetermined voltage and may actually have a negative value when the erase time characteristics of the cells drastically varies in the chip. When the threshold voltage value becomes negative, it badly affects the reading as stated above and the chip including the negative threshold voltage memory transistor is deemed as defective.

Such a defective product must be found out by testing, such as the "depletion test", and should be eliminated quickly during the step of selection after wafers have been manufactured. In order to examine the existence of the negative threshold memory transistors, there is a known method comprising the steps of writing into a bit on a data line and deciding whether the nonselective leakage current affects the reading of the bit involved. This is based on the principle described with reference to Fig. 2.

In the aforementioned memory devices, data has to be written in each bit on a data line to detect the presence of the memory cell in which the threshold voltage becomes negative after the contents thereof are erased. The problem is that test time therefore becomes longer by a large margin.

Summary Of The Invention

The present invention solves the foregoing problems inherent in the above described memory devices by providing a semiconductor non-volatile memory device which makes it possible to detect the presence of a memory cell in which the threshold voltage becomes negative after an erase operation.

Typical embodiments according to the present invention, which will be described in greater detail subsequently will now be simply summarized as follows.

An electrically batch erasing type EEPROM includes a memory array of electrically erasable storage transistors (non-volatile storage elements) which are arranged in a matrix form.

In order to carry out the depletion test, in other words, to detect whether or not there exists a memory cell whose threshold voltage is negative after the contents thereof has been erased, according to the present invention, all word lines are made nonselective, i.e., all gates of all memory cells are grounded at the time of the depletion test. In other words, the memory device of the present invention has means for grounding all the memory cell gates (so that all the memory cell gates are substantially set at OV) and reading the information stored in the cells. Provided that the threshold values of all the memory cells are normal, that means there is a positive threshold voltage, no conducting memory cells exist and reading current ought to be 0. If, however, a reading current flows (nonselective leakage current exists), it means there exists a conducting memory cell, i.e., a memory cell whose threshold voltage is negative.

As a result, the quality of the memory array as a whole can simply be detected, depending on whether the reading current is detected in the depletion test mode.

As set forth above, according to the present invention, it is unnecessary to write data into a bit on a data line basis when a decision is to be made on whether there exists a memory cell whose threshold voltage is negative after the contents thereof are erased. The memory can thus simply be made for a short test time.

The above and other novel features of the present invention will become apparent from the detailed description given in this specification together with the accompanying drawings of the embodiments.

Brief Description Of The Drawings

Fig. 1 is a cross-sectional view for explaining one example of the conventional memory cell;
Fig. 2 is a schematic circuit diagram for explaining the read out operation of the conventional memory cell;
Fig. 3 is a cross-sectional view for explaining another conventional memory cell;
Fig. 4 is a characteristic diagram for representing a relationship between the erasing time and the threshold voltage value of the storage transistor;
Fig. 5a is a circuit diagram of a memory cell employed in EEPROM to which an embodiment of the present invention is applied;
Fig. 5b is a circuit diagram of the conventional memory cell;
Fig. 6 is a block diagram of an overall EEPROM according to an embodiment of the invention;
Fig. 7 is a block diagram of a circuit arrangement of a memory array unit and also a peripheral circuit of an EEPROM according to an embodiment of the invention;
Figs. 8a-8j and 9a-9c are circuit diagrams of a specific embodiment of the timing control circuit CNTR according to an embodiment;
Fig. 10 is an erasure control circuit diagram ERC according to an embodiment of the present invention;
Figs. 11a and 11b are circuit diagrams of the data output buffer DOB according to an embodiment;
Fig. 12 is a circuit diagram of the data input buffer according to an embodiment;
Fig. 13 is a diagram illustrating the principle of the present invention;
Figs. 14 and 15 show line address decoders XDCR according to an embodiment of the present invention;
Fig. 16 is another read circuit diagram according to an embodiment of the present invention;
Figs. 17-19 show sensing amplifiers embodying the present invention;
Fig. 20 is a circuit diagram of a memory array unit of EEPROM according to another embodiment;
Fig. 21 is a schematic block diagram of a microcomputer system employing an EEPROM, according to an embodiment;
Fig. 22 is a schematic block diagram for illustrating connections between an EEPROM and microprocessor CPU, according to an embodiment;

Detailed Description Of The Present Invention

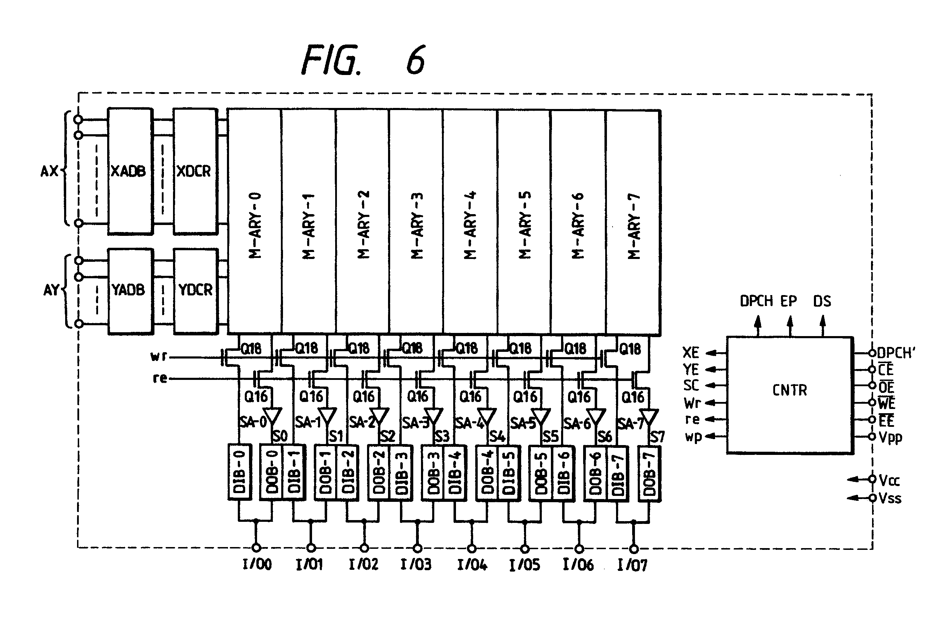

In Fig. 6, there is shown a block diagram of an electrically batch erasing type EEPROM (also referred to as "a flash EEPROM") to which the present invention has been applied. Each of circuit blocks shown in Fig. 6 is formed on a single semiconductor substrate by way of a well known semiconductor integrated circuit technique, although it is not necessarily limited thereto. Symbol "o" shown in Fig. 6 represents an external terminal provided on the flash EEPROM.

In the circuit of Fig. 6, each of M-ARY-0 to M-ARY-7 corresponds to a similarly constructed memory array. The respective memory arrays include a plurality of word lines, a plurality of data lines arranged in such a manner that these date lines cross (intersect) the above word lines, and that memory cells are respectively provided on each cross point which corresponds to an intersection between the corresponding word and data lines.

Symbol "XADB" indicates a row address buffer, and receives an external row address signal AX which is supplied via an external terminal so as to form an internal complementary row address signal corresponding to the row address signal AX. Symbol "XDCR" indicates a row address decoder and receives the internal complementary row address signal which has been formed by the row address buffer XADB so as to decode this internal row address signal. Although it is not limited thereto, both the row address buffer XADB and row address decoded XDCR are commonly used for the above-described memory addresses M-ARY-0 to M-ARY-7 in the preferred embodiment. That is, the row address decoded XDCR decodes the internal complementary row address signal so as to produce a word line selective signal for selecting a single word line in accordance with the external row address signal AX from a plurality of word lines in the respective memory arrays M-ARY-0 to M-ARY-7. As a result, a single word line is selected from the respective memory arrays M-ARY-0 to M-ARY-7.

In Fig. 6, symbol "YADB" denotes a column address buffer and receives an external column address signal AY which is supplied via the external terminal so as to produce an internal complementary column address signal in accordance with this external column address signal. Symbol "YDCR" represents a column address decoder, and decodes the internal complementary column address signal produced by the column address buffer YADB in order to produce a data line selective signal in accordance with the external column address signal AY. Although not shown in Fig. 6, a column switch is provided in each data line in the respective memory arrays M-ARY-0 to M-ARY-7, which receives the data line selective line, whereby a single data line, is selected in accordance with the external column address signal AY, from among a plurality of data lines within the memory array, and which is coupled to a common data line (not shown) corresponding to the memory array.

As previously described, in the respective memory arrays M-ARY-0 to M-ARY-7, a single data line and a single word line are selected in response to the external row address signal AX and external column address signal AY. In accordance therewith, a selection is made of a memory cell which corresponds to a location in the respective memory array at a cross point between the selected work line and data line. In other words, the memory cell coupled to the selected work line and data line is selected from a plurality of memory cells within all of the memory arrays. As a result, one memory cell is selected from the respective memory arrays.

Although it is not restricted thereto, with respect to the memory cells selected from the respective memory arrays in the preferred embodiment, both the write operation and read operation are performed substantially simultaneously. That is to say, either the write operation of the information, or the read operation thereof is carried out in connection with an 8-bit data unit. To this end, there are eight external input/output terminals I/00 to I/07 associated with the flash EEPROM according to the preferred embodiment. Between the respective memory arrays M-ARY-0 to M-ARY-7 and the corresponding external input/output terminals I/00 to I/07, there are provided a data input buffer DIB, a data output buffer DOB, a sense amplifier SA, and switching MOSFETs Q18 and Q16.

In the case of a writing operation of, for instance, the memory array M-ARY-0, the selected memory cell is coupled via MOSFET Q18, which is turned (switched) ON in response to the write control signal "wr," to the output node of the data input buffer DIB-0. In the reading operation, the selected memory cell is coupled via MOSFET Q16, which is turned (switched) ON in response to the read control signal "re," to the input node of the sense amplifier SA-0. The external input/output terminal I/00 is connected to the input node of the above-described data input buffer DIB-0 and is also coupled to the output node of the sense amplifier SA-0 via the data output buffer DOB-0. The remaining memory arrays M-ARY-1 to M-ARY-7 are respectively coupled to the external input/output terminals I/01 to I/07, similarly to the above-described memory array M-ARY-0.

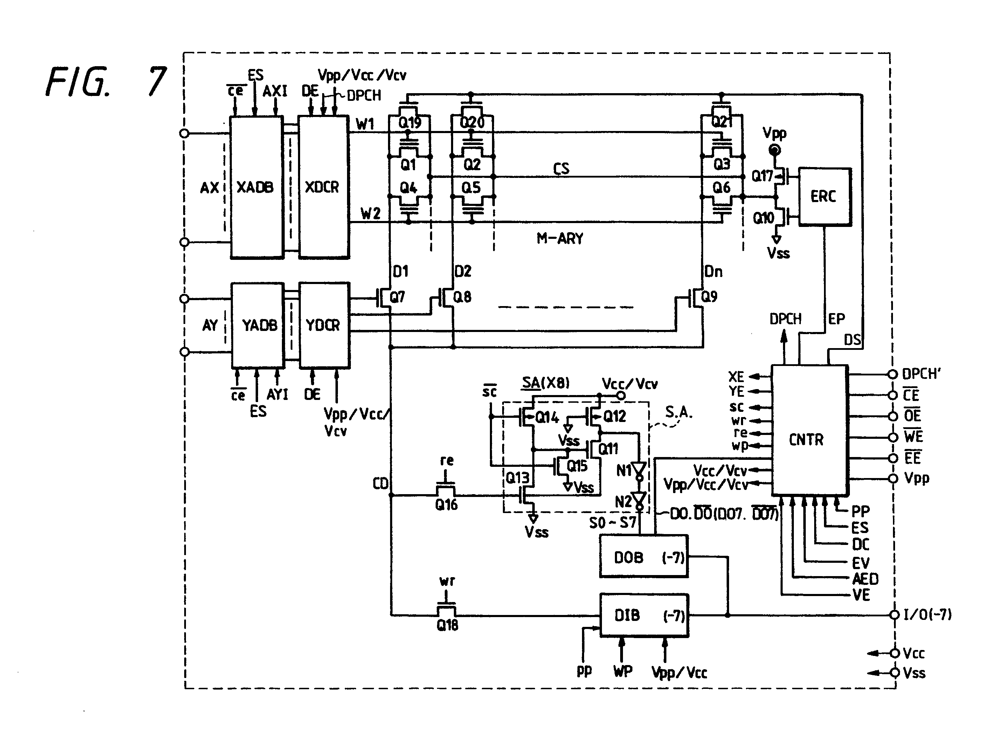

In Fig. 6, symbol "CNTR" is a timing control circuit which generates a timing signal including the above-described control signals wr, re and so on in response to the external signal or voltage to be supplied to the external terminals $\overline{CE}$, $\overline{OE}$, $\overline{WE}$, $\overline{EE}$. DPCH′ and Vpp (described in greater detail below with regard to Fig. 7). In Fig. 6, symbol "Vcc" denotes an external terminal of the EEPROM for applying a power source voltage Vcc to the respective circuit blocks, and symbol "Vss" is an external terminal for applying a ground potential "Vss" to the respective circuit blocks. Symbol "DPCH" denotes an external terminal of the EEPROM for applying a depletion test mode signal. A depletion test signal "DPCH" is generated in the "CNTR" in response to the "DPCH′".

It should be noted that the word lines were subdivided into individual groups of word lines wherein each group is correspondingly associated with an individual memory array in the above-described description; however, the word lines employed may be common to each and every one of the memory arrays.

In Fig. 7, there is shown a detailed block diagram relating to a single memory array in the flash EEPROM shown in Fig. 6, a peripheral circuit of this memory array, a row address buffer, a column address buffer, a row address decoder, a column address decoder, and a timing control circuit (CNTR). As is readily understood from the foregoing description, the respective circuit elements shown in Fig. 7 are formed on a single semiconductor substrate such as a monocrystal (single crystal) silicon by way of a known manufacturing technique with respect to CMOS complementary type MOS integrated circuit technology, although not limited thereto. In the circuit shown in Fig. 7, a P-channel MOSFET is discriminated from an N-channel MOSFET by adding an arrow to a channel (back gate) of the first-mentioned MOSFET. This fact is also applied to other figures (to be discussed later).

Although it is not restricted thereto, the integrated circuit is fabricated on a monocrystal P-type silicon. The N-channel MOSFET is constructed of a source region formed on this semiconductor substrate surface; a drain region; and a gate electrode which is made from a polysilicon formed on the semiconductor substrate surface between the drain region and source region via a thin gate insulating film. On the other hand, the P-channel MOSFET is formed in an N-type well region fabricated on the above-described P-type monocrystal semiconductor substrate surface. As a result, the semiconductor substrate constitutes a common substrate gate for a plurality of N-channel MOSFETs formed thereon, to which the ground potential "Vss" of the circuit is applied. The N-type well region constitutes a substrate gate of the P-channel MOSFET formed thereon. The power supply voltage Vcc is applied to the substrate gate of the P-channel MOSFET, namely N-type well region. It should be noted that a high voltage Vpp externally applied via the external terminal Vpp, or another high voltage produced inside the EEPROM is applied to the N-type well region where the P-channel MOSFET is formed and which high voltage is effected by a circuit that processes a voltage higher than the power supply voltage Vcc.

Alternatively, the above-described integrated circuit may be fabricated on a semiconductor substrate made of a monocrystal N type silicon. In this case, an N-channel MOSFET and a nonvolatile memory (storage) element are formed on a P-type well region, whereas a P-channel MOSFET is formed on the above-described N type semiconductor substrate.

A more detailed description will now be given of the flash EEPROM according to the preferred embodiment with reference to Fig. 7. For the sake of brevity and facilitating greater understanding, the same explanations as those for EEPROM shown in Fig. 6 apply in connection with the following descriptions.

In the flash EEPROM according to an embodiment of the present invention, the internal complementary signal is produced by the address buffers XADB and YADB which receive X(row) and Y-(column) address signals AX and AY supplied via the external terminal from the external unit, and then supplied to the address decoders XDCR and YDCR, although it is not limited thereto. The above-described address buffers XADB and YADB are initialized by the internal chip selecting signal $\overline{ce}$, and in conjunction therewith the buffers fetch the external address signals AX, AY supplied from the external terminals, and, in accordance therewith, each buffer produces a complementary address signal constituted by an internal address signal having the same phase as that of the external address signal supplied from the external terminal, and an internal address having the phase opposite to that of the external address signal, although it is not restricted thereto. To the above-described address buffers XADB and YADB, a signal ES which is representative of the erasing mode, and the internal address signal AXI, AYI and the like in addition to the above-described chip selecting signal $\overline{ce}$ are supplied. Because these signals as ES, AXI, YAI are signals to be used in the erasing mode, these signals do not affect the operation of the address buffers XADB and YADB during the normal writing mode or reading mode associated with the flash EEPROM.

The row (X) address decoder XDCR is initialized by the address decoder initializing signal DE and, upon being initialized, produces a selection signal for selecting one word line from a plurality of word lines within the memory array M-ARY in accordance with the complementary address signal derived from the corresponding address buffer XADB.

Similarly, the column (Y) address decoder YDCR is initialized in response to the above-described address decoder initializing signal DE, and it produces a selection signal for selecting one data line from a plurality of data lines within the memory array M-ARY in accordance with the complementary address signal derived from the corresponding address buffer YADB.

The above-described memory array M-ARY includes a plurality of word lines, a plurality of data lines arranged to be crossed (intersected) with the plural word lines, and a plurality of memory cells provided at the cross points (intersections) between these word and data lines. In this drawing, a portion of this memory array M-ARY is illustrated as a typical example. That is to say, in Fig. 7 there is shown the word lines W1 and W2 among a plurality of word lines; the data lines D1, D2 and Dn among a plurality of data lines; and memory cells provided at the cross points of these data lines and word lines. Each of the memory cells is constructed of, as previously described with reference to Fig. 5a, a single storage transistor (nonvolatile memory element). In other words, each of these memory cells is constructed of a single storage (memory) transistor having a stacked gate structure including a control gate and a floating gate. As previously described, the above-described storage transistor has a similar structure to a storage transistor of EPROM. It should be noted that as previously described, the erasing operation is electrically carried out by utilizing the tunneling phenomenon between the floating gate and the source region coupled to the source line CS, which is different from the erasing method employed in EPROM which utilizes ultraviolet radiation.

In the above-described memory array M-ARY, the control gates (selecting nodes of the memory cells) of the storage transistors Q1 to Q3 (Q4 to Q6) arranged on the same column are connected to the corresponding word lines W1 (W2), whereas the drain regions (input/output nodes of the memory cells) of the storage transistors Q1, Q4 to Q3, Q6 arranged on the same row are connected to the corresponding data lines D1 to Dn. The source regions of the storage transistors are coupled to the source line CS.

In accordance with this embodiment, both an N-channel MOSFET Q10 (pull-down MOSFET) and P-channel MOSFET Q17 (pull-up MOSFET) which are switch-controlled by the erasing circuit ERC are connected to the source line CS. This erasing circuit ERC enables the N-channel MOSFET Q10 to be turned on during the writing mode and reading mode, so that the ground potential Vss of the circuit is applied to the source line. On the other hand, during the erasing mode, the P-channel MOSFET Q17 is turned on whereby the high voltage Vpp for erasing purposes is applied to the source line CS.

If the above-described memory array M-ARY is partially erased, the storage transistors arranged in a matrix form are subdivided into M blocks along a longitudinal direction, and source lines corresponding to the above-described source lines are respectively provided in each of the blocks. An erasing circuit ERC and MOSFETs Q10 and Q17 are provided on the respective source lines CS employed in each of the respective blocks. In this case, in order to determine which one of the plurality of blocks is being erased, it is required to address the respective erasing circuits by an address signal which specifies the block. In the above-described preferred embodiment, the information stored in all of the memory cells constituting the memory array M-ARY is erased within a single time period. In this case, the number corresponding to the source line CS is selected to be one, and the above-described erasing circuit ERC and MOSFETs Q10 and Q17 are provided in connection thereto.

In an EEPROM according to this embodiment, since the writing/reading operations are performed in a unit of plural bits such as 8 bits, the above-described memory arrays M-ARY comprise 8 arrays (M-ARY-O to M-ARY-7) in total, as illustrated in Fig. 1. It should be understood that when 16-bit information is read/written, 16 sets of the above-described memory arrays M-ARY are employed.

The respective data lines D1 to Dn constituting a single memory array are selectively connected via column selecting MOSFET switches Q7 to Q9 (column switch) to the common data line CD in response to a data line selecting signal from the column address decoder YDCR. To this common data line CD, the output terminal of the data input buffer DIB for the writing operation, which receives the write data input from the external terminal I/O, is connected via the MOSFET switch Q18. Such column selecting MOSFET switches, similar to that of Fig. 6, are also employed in the remaining 7 memory arrays M-ARY, to which the selection signals derived from the column address decoder YDCR are supplied. It should be noted that, additionally, different column address decoders may be provided with each one of the respective memory arrays. Each decoder, by way of selection signals, controls the selection of MOSFET switches of its respective array.

The common data line CD, provided correspondingly with the memory array, is coupled to an input terminal of a first stage amplifier circuit which constitutes an input stage circuit of a sense amplifier SA via the MOSFET switch Q16. For the sake of convenience, the multi-stage sensing circuit is herein referred to as "a sense amplifier SA" including a circuit which is arranged by MOSFETs Q11 to Q15 as the above-described first stage amplifier circuit and a cascade-connected CMOS invertor circuit which includes CMOS logic inverters N1 and N2. During normal read out operating conditions (normal read out mode), the relatively low power supply voltage $V_{CC}$ is applied as the power supply for the sense amplifier SA to the power supply voltage terminal $V_{CC}/V_{CV}$ associated with the sense amplifier SA, whereas a voltage $V_{CV}$ having a potential of a magnitude lower than the above-described power supply voltage $V_{CC}$ is applied as the power supply to the power supply voltage terminal $V_{CC}/V_{CV}$ during the erase verifying operation, which will be subsequently described.

The common data line CD as illustrated above, is connected via MOSFET Q16, which is brought into the ON-state in response to the read control signal re, to the source of the N-channel amplifier MOSFET Q11. A P-channel type load MOSFET Q12, to which gate electrode and the ground potential $V_{SS}$ of the circuit is being applied, is provided between the drain of this amplifier MOSFET Q11 and the power supply voltage terminal $V_{CC}/V_{CV}$ of the sense amplifier SA. The above-described load MOSFET Q12 applies a precharge current to the common data line CD for the read operation.

To increase the sensitivity of the amplifier MOSFET Q11, the voltage of the common data line CD via the MOSFET switch Q16 is being applied to the gate of the driver MOSFET Q13 corresponding to the input of the inverting amplifier circuit which further includes the N-channel driver MOSFET Q14. The output voltage of the inverting amplifier circuit is applied to the gate of the amplifier MOSFET Q11. In addition, in order to prevent unnecessary current consumption of the sense amplifier during the nonoperative period of the sense amplifier SA, an N-channel shunting MOSFET Q15 is provided between the gate of the amplifier MOSFET Q11 and the ground potential point of the circuit. An operation timing signal $\overline{sc}$ of the sense amplifier is commonly supplied to the gates of this MOSFET Q15 and P-channel MOSFET Q14.

When the memory cell is read out, the operation timing signal $\overline{sc}$ of the sense amplifier SA is set to a low level. As a result, MOSFET Q14 is brought into an ON-state and MOSFET Q15 is brought into an OFF-state. The storage transistor constituting the memory cell holds previously written data of either the higher threshold voltage, or lower threshold voltage than that corresponding to the selection level of the word line which is applied during the read operation.

In the case where a single memory cell which is selected from a plurality of memory cells constituting the memory array M-ARY in accordance with the respective address decoders XDCR and YDCR during the read operation is brought into the OFF-state, even if the word line is set to the selecting level, the common data line CD is set to the high level or a first voltage by the current supplied through MOSFETs Q12 and Q11 and thus by the voltage drop there across from the voltage value of the SA supply terminal $V_{CC}/V_{CV}$ associated with the read out mode, i.e. $V_{CC}$. On the other hand, in the case where the above-described selected memory cell is brought into the On-state in response to the selecting level of the word line, the common date line CD is set to a low level or a second voltage which is determined by the voltage division of the series coupling of the series connected MOSFETs Q11, Q12, the column MOSFET switch (one of MOSFETs Q7-Q9) and the storage transistor of the selected memory cell. Therefore, this second voltage has a value which is between that of the first voltage (high level) and ground potential ($V_{SS}$), i.e. voltage $V_{CC}$ > the first voltage > the second voltage. By applying this relationship to the common data line, the speed-up of the read out operation can be realized because the change in voltage on the common data line between that of the high level and that of the low level, which is indicative of binary data write information stored in a memory cell, is small. Control of the sense amplifier SA amplifier MOSFET Q11, at the gate electrode thereof, is effected by the MOS inverting amplifier circuit (Q13, Q14) which has an output coupled to the gate of MOSFET Q11. In the data line discharge MOSFETs Q19 to Q21, which are provided between the respective data lines D1 to Dn and source line, since the gate bias signal DS supplied to gates thereof is set to the intermediate level (to be discussed later), the charge in those data lines which have not been selected by the column address decoder YDCR is discharged.

It should be noted that the above-described amplifier MOSFET Q11 performs the amplification of the gate grounded type source input, and transfers the output signal thereof to an input of a CMOS inverter circuit N1. A CMOS inverter circuit N2 produces a signal SO (in the case where the memory array M-ARY shown in Fig. 7 corresponds to the memory array M-ARY-O shown in Fig. 6 which is obtained by shaping the waveform of the output signal from the CMOS inverter circuit N1 by the inverter N2, wherein this signal SO is transferred to the data output buffer DOB-O. The data output buffer DOB-O amplifies the above-described signal SO and delivers it to the external terminal I/O$_O$.

The data buffer not only has the above-described output function of the data readout, but also includes the following functions. The data output buffers DOB-O to DOB-6 respectively corresponding to the external input/output terminals, perform an output operation in accordance with three conditions, one of which being a high impedance state condition, in response to the data output buffer initializing signals DO and $\overline{DO}$. However, the data output buffer DOB-7 corresponding to the external input/output terminal I/O7 is under the control of the data initializing signals D07 and $\overline{DO7}$ which are different from the above-described signals DO and $\overline{DO}$. This data output buffer DOB-7 is employed so as to be used in a data polling mode by which the internal erasing condition of the EEPROM is externally read. The write data supplied from the external input/output terminal I/O is transferred via the data input buffer DIB to the above common data line CD. As is shown in Fig. 6, both the read circuit constructed of a sense amplifier SA, which includes an input stage circuit, and data output buffer DOB similar to those of the above-described circuits, and also the write circuit constructed of the data input buffer DIB are similarly commonly provided between the common data line and external input/output terminal with respect to each of memory arrays M-ARY.

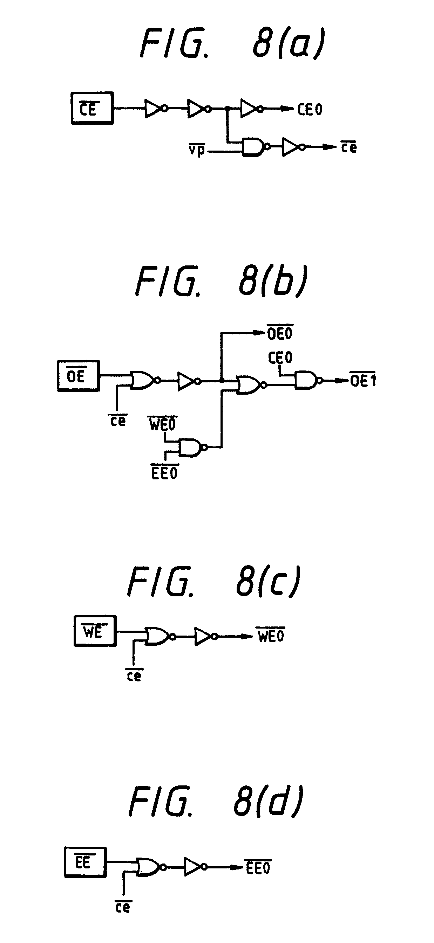

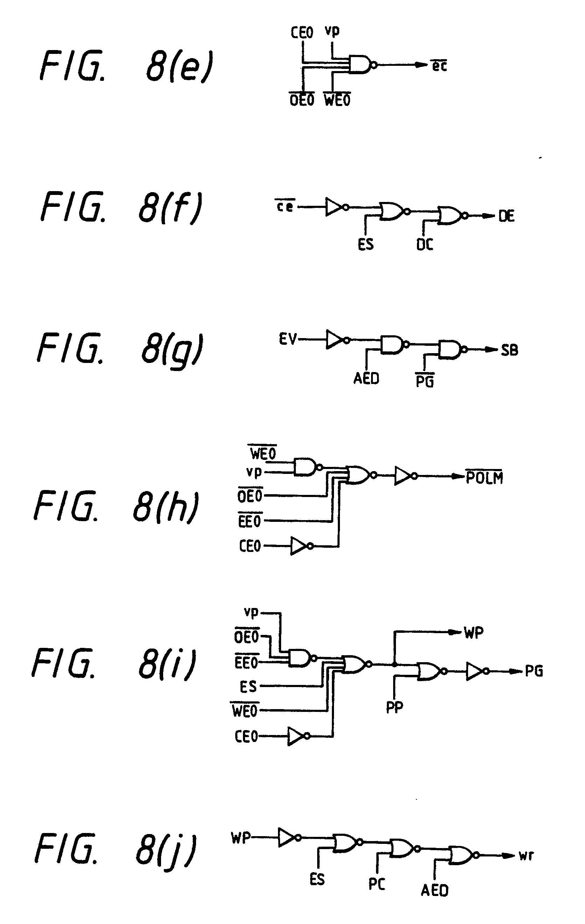

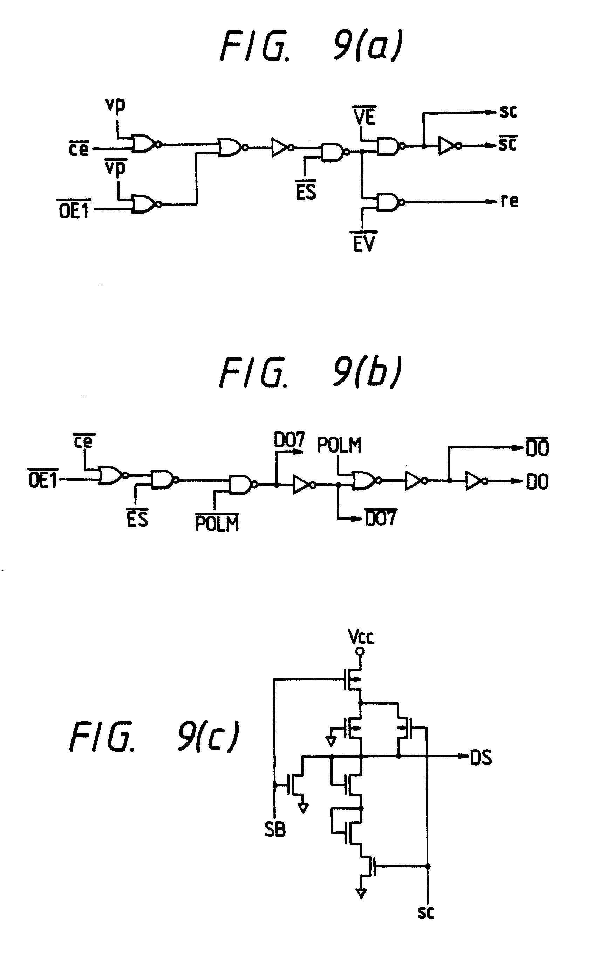

The timing control circuit CNTR generates internal timing signals such as: the internal control signal $\overline{ce}$ and an operation timing signal $\overline{sc}$ of the

sense amplifier, and changes to the voltages of the reading low voltage $V_{CC}$/erase-verifying low voltage $V_{CV}$/writing high voltage $V_{PP}$ which are selectively supplied from the address decoder and the like so as to selectively output any one of these voltages in response to a chip enable signal $\overline{CE}$, an output enable signal $\overline{OE}$, a write enable signal $\overline{WE}$, an erase enable signal $\overline{EE}$ and write/erase high voltage $V_{PP}$, which are supplied to the external terminals $\overline{CE}$, $\overline{OE}$, $\overline{WE}$, $\overline{EE}$ (simply referred to as signals $\overline{CE}$, $\overline{OE}$, $\overline{WE}$ and $\overline{EE}$) and also in response to $V_{PP}$, and furthermore a prewrite pulse PP, a signal indicative of the erase mode ES, a decoder control signal DC, an erase-verify signal EV, an automatic erase mode setting delay signal AED, a sense amplifier initializing signal VE for the verify mode. In addition, the timing control circuit generates depletion test signal DPCH in response to the signal DPCH' which indicates depletion test mode. The depletion test signal DPCH is "high" level during the depletion test mode, and the signal DPCH is transferred to row address decoder XDCR. In Figs. 8(a) to 8(j) and 9(a) to 9(c), there are shown circuit diagrams of the major circuit portions of the timing control circuit CNTR according to one preferred embodiment of this invention. Although detailed operations of the circuits in Figs. 8(a) to 8(j) and 9(a) to 9(c) are not described, the operation will be readily understood from the explanation below.

The operation of this memory device will be explained below. In the read mode, the internal signal $\overline{ce}$ is set at "low", whereas DE, $\overline{sc}$, re are set at "high". The address decoder circuits XDCR, YDCR are thereby activated, whereby one word line and one data line are selected.

The low voltage Vcc as operating voltage is supplied to the address decoder circuit XDCR, YDCR and a data input circuit DIB. Moreover, since $\overline{sc}$ becomes "high", the MOSFET Q14 is held on, whereas the MOSFET Q15 is held off.

On the other hand, the memory cells Q1-Q6 have a high or low threshold voltage according to the prewritten data with respect to the selected level of the word line.

When the threshold voltage of the memory cell selected by the address decoders XDCR, YDCR is high and when the memory cell is held off, despite the word line at the selective level, the common data line CD is supplied with the current by the MOSFETs Q12, Q11 and set at a relatively "high" level. When the threshold voltage of the memory cell thus selected is low and held on by the word line selection level, on the contrary, the common data line CD is set at a relatively "low" level.

In this case, the "high" level of the common data line CD is restricted to a relatively low potential as the relatively "low" level output voltage formed by an inverted amplifier circuit for receiving the "high" level is supplied to the gate of the MOSFET Q11. On the other hand, the "low" level of the common data line CD is restricted to a relatively high potential as the relatively "high" level output voltage formed by the inverted amplifier circuit for receiving the "low" level is supplied to the gate of the MOSFET Q11.

The aforementioned MOSFET Q11 performs the operation of amplifying a gate grounding-type source input and transmits the output signal to the CMOS inverter N1. The output signal of N1 is further subjected to waveform rectification in the invertor N2. The output signals SO-S7 from the inverter N2 become "high" when the threshold voltage of the memory remains "high", and become "low" when it is low. The aforementioned signals are amplified by a corresponding data output buffer DOB, which is not restricted to what is shown, before being sent out of the external terminal I/O.

There is also provided the read circuit constituted by a sensing amplifier and a data output buffer likewise between the common data line CD corresponding to the other memory blocks and the external terminal I/O.

In addition, a gate signal DS from MOSFETs Q19-Q21 is deemed an intermediate value between Vcc and 0 V, whereby charge is discharged from the data line in the nonselective state.

In the write mode, the internal signal $\overline{ce}$ is subsequently set at "low"; DE, wr at "high"; and $\overline{sc}$, re at "low." The address decoder circuits XDCR, YDCR are thus activated, whereby one word line and one data line are selected.

Moreover, the high voltage Vpp as the operating voltage is supplied to the address decoder circuits XDCR, YDCR and the data input circuit DIB.

The MOSFETs Q16, Q19-Q21 are turned off and the data output buffer DOB, and the sensing amplifier are prevented from being activated.

The word line to which data is written has the aforementioned high voltage Vpp. The data line connected to the memory cell which should operate to inject electrons into the floating gate is connected via MOSFET Q18 and the data input buffer DIB to the high voltage Vpp.

With the aforementioned operation, data is written to the memory cells.

Electrons are stored in the floating gate of the memory cell loaded with the data written thereto and the threshold voltage of the memory cell becomes high and no drain current is allowed to flow therethrough even though any one of the word lines is selected.

While no electrons are injected, i.e., no data is written thereto, the threshold voltage is so low as to make the current to flow when the word line is selected.

Even between the common data line corresponding to the other memory block and the external terminal, there is provided the write circuit comprising the input stage circuit and the data input buffer DIB likewise.

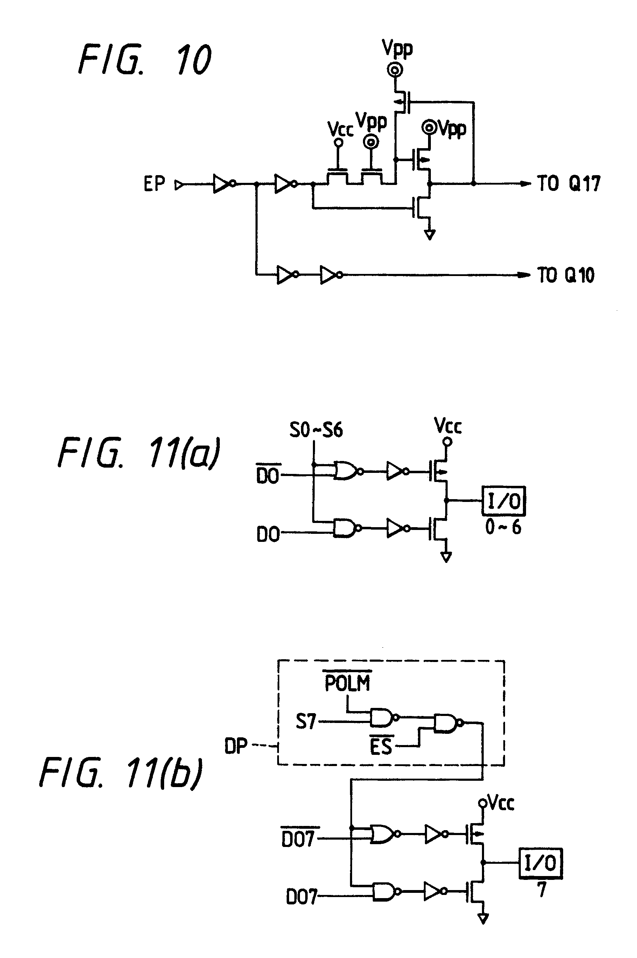

In the erasure mode, subsequently, all of the word lines are set nonselective and high voltage is applied via the erasure control circuit ERC to the memory cell whose contents should be erased. The erasure control circuit ERC is arranged as shown in Fig. 10, for instance.

In Fig. 10, EP denotes a signal which becomes "high" during the erasure period and its inverted signal is basically transmitted to the gate of the PMOSFET Q17 via the inverter with the Vcc as a power supply and a high-voltage inverter, and to the gate of the NMOSFET Q10 via the two-stage inverter with the Vcc as the power supply. As stated above, the erasure and read modes are alternately repeated properly so that the lower limit of the readable source voltage Vccmin becomes what has been desired.

Detailed circuits of the data output buffer DOB are shown in Fig. 11(a) and 11(b). Both arrangements of the data output buffers DIB-O to DIB-6 corresponding to the external input/output terminals $I/O_0$ to $I/O_6$, and the data output buffer DIB-7 corresponding to the external input/output terminal $I/O_7$, correspond to a 3-state output circuit including a high impedance, respectively, except for the data polling (status polling) control circuit DP. As previously described in the read out mode, when the initializing signals DO and D07 become high levels, such an operation is executed that the output signals SO to S7 derived from the sense amplifier SA are output after being inverted. To the contrary, since the initializing signal $\overline{POLM}$ becomes a low level in the data polling mode (status polling mode), the output signal S7 is invalidated, and the output signal of the terminal $I/O_7$ is determined in accordance with the level of the signal $\overline{ES}$ indicative of the erase mode. That is to say, since the signal $\overline{ES}$ representative of the erase mode becomes a low level during the erasing mode, the low-level signal is output from the external input/output terminal $I/O_7$. When the erase operation is completed, the high-level signal is output.

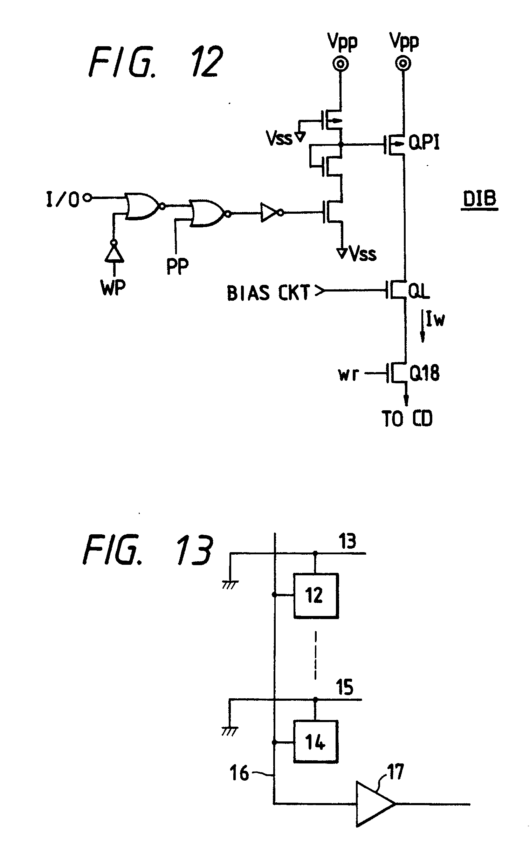

In Fig. 12, there is shown a circuit diagram of the data input buffer DIB according to one embodiment.

This data input buffer DIB is commonly used in the case for when the data supplied from the external input/output terminal I/O is to be written into the memory cell, and also the predetermined data which is written into the memory cell during the prewrite operation. In the case of a write mode, the write mode signal WP is set to a high level, and also a prewrite pulse PP is set to a low level. As a result, the data supplied to the external input/output terminal I/O is transferred via two NOR circuits to the input node of the MOS invertor. After the data transferred to the input node is phase-inverted by the MOS invertor, it is supplied to the bias circuit where a single P-channel MOSFET QPI and two N-channel MOSFETs QL and Q18 are series-connected. The above-described data whose level has been converted into a predetermined level by the bias circuit is supplied to the gate of the writing P-channel QPI. This writing P-channel MOSFET QPI is coupled via MOSFET QL, having a gate to which a predetermined bias voltage is applied, and MOSFET Q18 to a common data line CD and is, furthermore, coupled via a selected data line to a drain of a memory cell (storage transistor) to be written. The P-channel MOSFET QPI supplies the voltage in accordance with the data to be written to the drain of the memory cell and, as a result thereof, the data of the memory cell selected is written.

A description will subsequently be given of a depletion test featuring the present invention.

In the test mode (depletion test mode) to search for the presence of a memory cell whose threshold voltage is negative, the same operation as that in the normal read mode is performed except that all the word lines are made nonselective (i.e., the gates of all the memory cells are grounded).

Fig. 13 is a diagram illustrating a wiring condition at the time of the aforementioned depletion test to detect whether or not there exists the memory cell whose threshold voltage is negative after the contents thereof has been erased therefrom. As shown in Fig. 13, the word lines 13, 15 of all memory cells are grounded at the time of the depletion test. In other words, all the memory cell gates are grounded and reading is done in this condition.

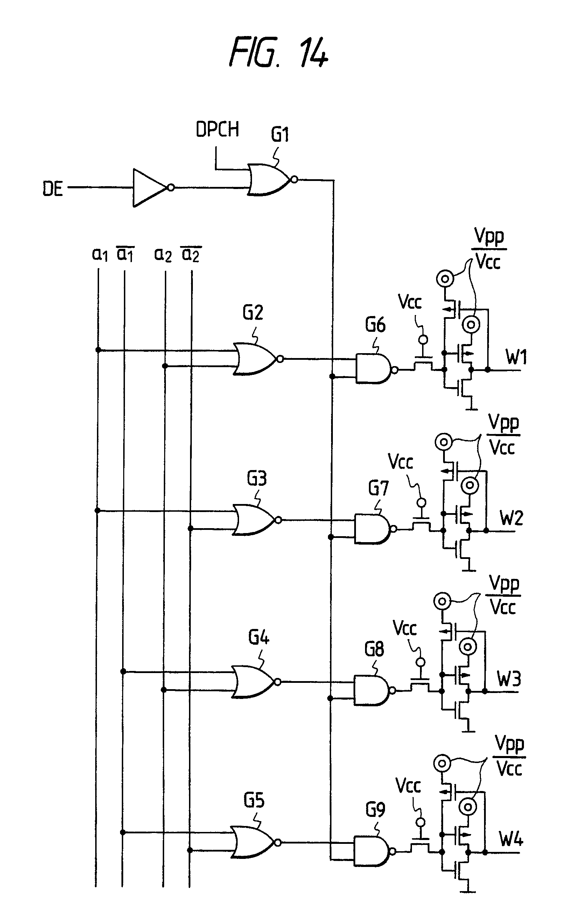

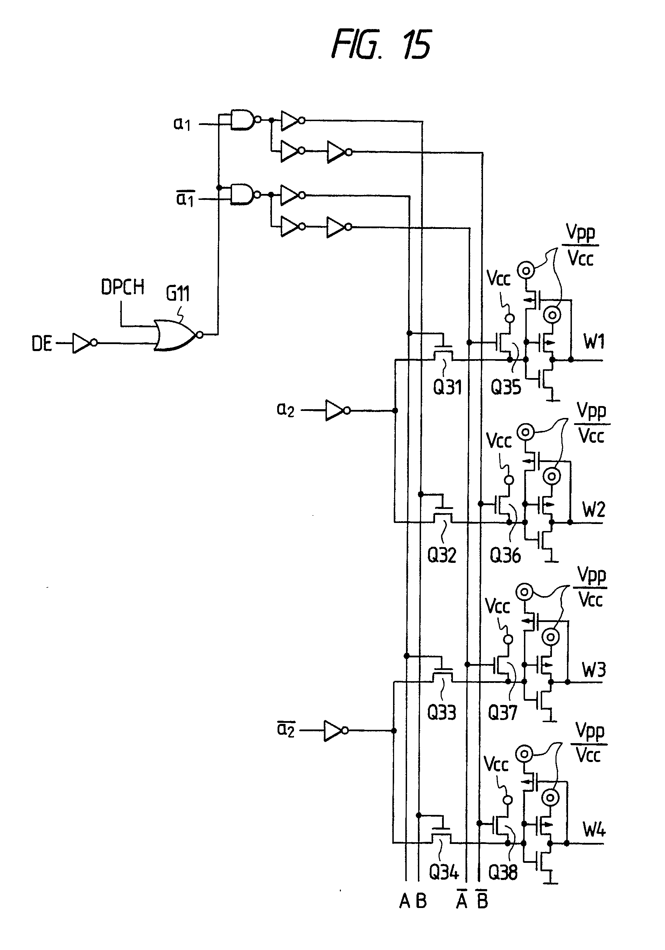

To realize the aforementioned arrangement row address decoder XDCR is formed as shown in Fig. 14 or 15.

Figs. 14, 15 refer to a case where two sets of complementary address signals a1, $\overline{a1}$, and a2, $\overline{a2}$ are used to form four word lines. In Figs. 14, 15, DPCH denotes a signal that is made "high" in this test mode. When the DPCH is "high", all word lines are grounded through n-channel transistors. As a result, all the word lines are made nonselective regardless of the address signal.

The operation of the row address decoder XDCR in Fig. 14 is first described. Under the normal read or write operation, the output of NOR gate G1 is "high", as the signal DPCH is "low" and the signal DE is "high". On the other hand, one of four NOR gates G2-G5 outputs "high" and the other three gates output "low", in response to the address signals $a_1$, $\overline{a_1}$, $a_2$, $\overline{a_2}$. Then, NAND gates G6-G9 transfer the outputs of the NOR gates G2-G5, respectively, by inverting. One of G6-G9 outputs "low" and the other three output "high". The word lines W1-W4 are connected to the outputs of G6-G9, respectively, via inverting circuits. As a result, one of the word lines becomes selective voltage (Vcc) and the other three become non-selective voltage (GND).

Under the depletion test, in contrast to the above read or write operation, the signal DPCH is "high" and the output of G1 is "low". Accordingly, all outputs of G6-G9 are always "high" and all word lines are kept at non-selective voltage (GND), regardless of the address signals.

As to the row address decoder XDCR in Fig. 15, the basic operation is almost the same as that in Fig. 14, even though the circuit configuration is different. As output of NOR gate G11 is "high", one of the word lines becomes selective voltage (Vcc) and the other three become non-selective voltage (GND) in response to the address signals, under the normal read or write operation.

Under the depletion test, the signal lines A and B are kept "low" and the signal lines $\overline{A}$ and $\overline{B}$ are kept "high" regardless of the address signals because the signal DPCH is "high" and the output of G11 is "low". Then, transistors Q31-Q34 are all turned off and the address signals $a_2$, $\overline{a_2}$ are neglected. On the other hand, transistors Q35-Q38 are all turned on and Vcc is inputted to all inverting circuits. Accordingly, all word lines are kept at non-selective voltage (GND), regardless of the address signals.

On the other hand, the operation of the column decoder YDCR is same as that of normal read or write operation. That is, the decoder YDCR controls transistors Q7-Q9 so that one of these transistors are turned on in response to the column address signal AY. According to the above mentioned operation of the row address decoder XDCR and the column address decoder YDCR, detection of a memory cell in which the threshold voltage is negative can be carried out in each data line. And by changing the column address, all memory cells in the memory array can be tested quickly.

Of course, the signal DPCH can be also inputted to the column address decoder YDCR. By this arrangement, the decoder YDCR controls transistors Q7-Q9 so that these three are turned on simultaneously, in response to the signal DPCH. Then, contents of all memory transistors in the memory array can be read out at a time. In that case, however, it would take more time to complete the depletion test because of the increase of the data line capacity.

The signal DPCH can be inputted directly to the address decoder XDCR from an external terminal, or inputted to the address decoder via timing control circuit CNTR, as mentioned above.

In the depletion test mode as stated above, since all the word lines are made nonselective, i.e., the gates of all the memory cells are grounded, the gates of the all the memory cells are set at O V. As a result, no conducting memory cells exist, provided the threshold voltages of all the memory cells are normal, and the read current ought to be 0. If the read current flows (if nonselective leakage current exists), it means the presence of a conducting memory cell, i.e., the presence of a memory cell whose threshold voltage is negative.

In this depletion test mode, the quality of the memory array as a whole can simply be detected, depending on the presence of the read current. A semiconductor memory device, which is found to include the negative threshold voltage bit by the depletion test, should be eliminated as a detective product.

In the semiconductor memory device, in general, additional word lines are sometimes provided for relieving defects of the memory cell. For example, two additional word lines are provided for each side of the normal word lines, and memory cells are also provided for the additional word lines. If the source, drain and gate electrodes of the memory cells corresponding to the additional word lines are connected as the normal memory cells, the memory cells corresponding to the additional word lines should be also depletion - tested, and the additional word lines should be grounded at the depletion test mode.

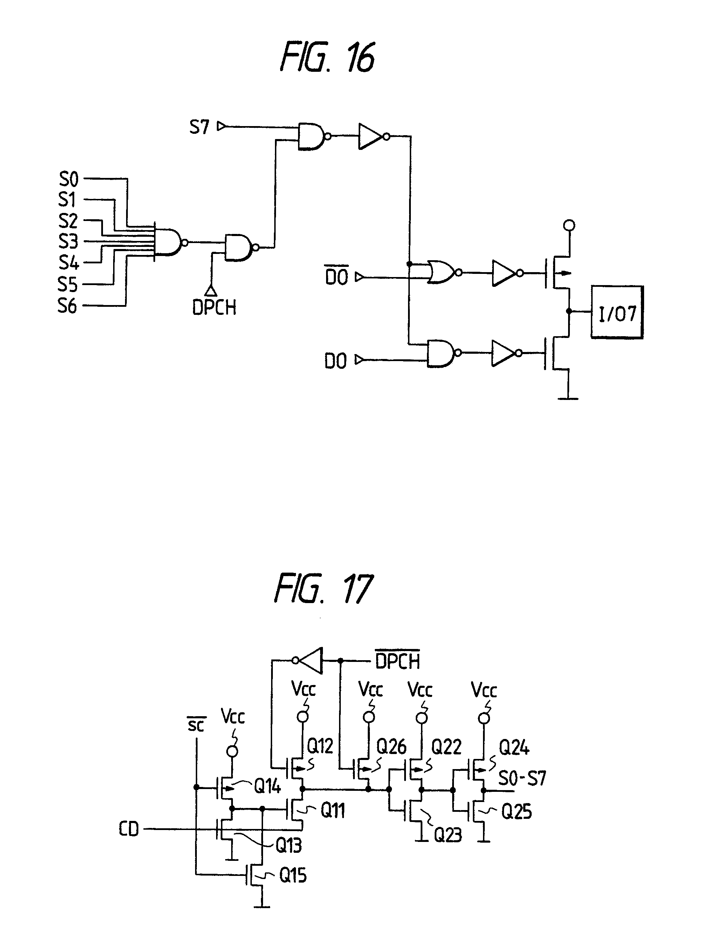

Although the basic operation in the depletion test mode is as what has been described above, the present invention is not limited to that example. The data line may be selected sequentially within the circuit, for instance, instead of the selection thereof made according to the external address signal as shown above. In the case of 8 bits as a unit, although the output of the 8-bit unit outputs SO-S7 may be utilized as shown in Fig. 16 only in the depletion test mode so that a 1-bit signal is generated when at least one of the outputs is "low", i.e., when the nonselective leakage current is judged to be present. In the embodiment shown, the I/O₇ terminal has been shown as an intended output end by way of example. DO in Fig. 16 denotes a signal for activating the data output buffer DOB.

The sensitivity of the sensing amplifier may be changed to increase the sensitivity of depletion bit detection in the depletion test mode. Although the MOSFET Q12 acts equivalently as a load resistor, for instance, its equivalent resistance may be increased so that traces of nonselective leakage current may be used for making a decision.

Figs. 17-19 show arrangements of sensing amplifiers by way of example.

In Fig. 17, the MOSFET Q12 is employed as a load resistor in the normal read mode, whereas the MOSFET is switched over to a MOSFET Q26 having a greater equivalent resistance in the depletion test model

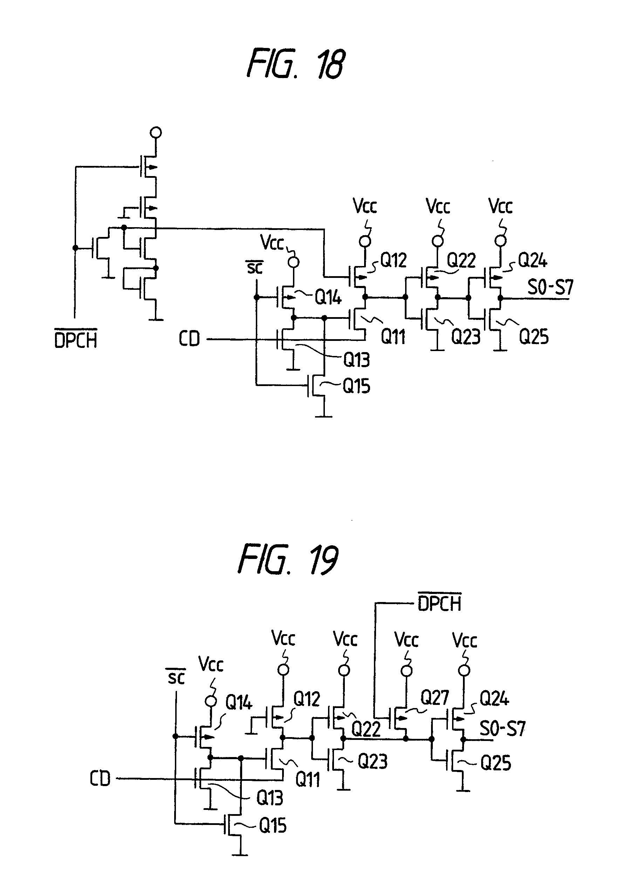

In Fig. 18, there is shown an example of supplying an intermediate voltage between O V and Vcc to the gate of MOSFET Q12 as a load resistor in the depletion test mode.

In Fig. 19, the example shown refers to a case where the level at which the voltage at the nodal point A is judged "high" or "low" is set higher than that at the normal reading in the depletion test mode by turning on a MOSFET Q27.

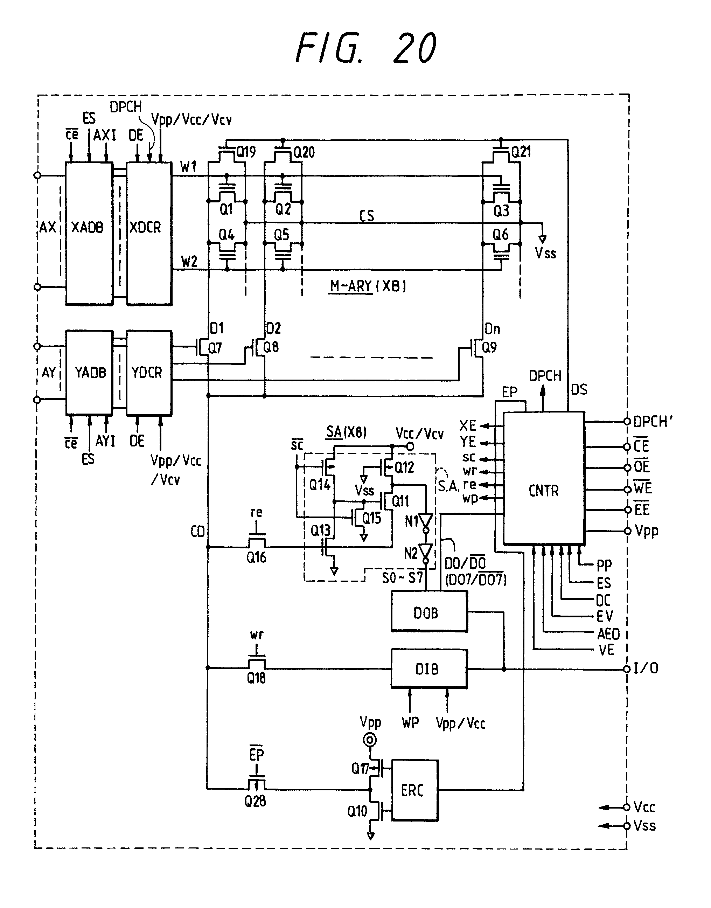

Fig. 20 represents a circuit diagram of another embodiment of an EEPROM according to the present invention. In this embodiment, there are only shown a single memory array and a peripheral circuit thereof, which is similar to the previous embodiment shown in Fig. 7. An overall circuit of this embodiment will be referred to the circuit shown in Fig. 6.

In accordance with the memory cell of EEPROM according to this embodiment, the erasing operation is electrically performed at the drain region side, instead of the source region side as performed in the previous embodiment.

That is to say, a source line of a memory array M-ARY is fixedly connected to a ground potential point $V_{SS}$ of a circuit thereof according to this embodiment.

The combination of an erasing circuit ERC, the above-described P-channel MOSFET Q17 switched by this erasing circuit, and an output node of an N-channel MOSFET Q10 are coupled to a common data line CD via a P-channel type switching MOSFET Q28. The switching MOSFET Q28 has a gate to which the above-described erasing pulse $\overline{EP}$ is applied. As a result, the switching MOSFET Q28 is brought into the ON-state during a time period in which the erasing pulse $\overline{EP}$ is set to a low level, and a high voltage $V_{PP}$ which is output via a P-channel MOSFET Q17 is transferred to the common data line CD. This P-channel MOSFET Q17 is brought into an On-state based upon the low level of the erasing pulse $\overline{EP}$. In order to erase all of the memory cells within the memory array M-ARY in a batch mode, an address decoder YDCR enables all of the column switch MOSFETs Q7 to Q9 to be turned ON so as to transfer the high voltage $V_{PP}$ of the above-described common data line CD to the data line in response to, for instance, the erasing pulse $\overline{EP}$. Instead of this arrangement, if the column decoder YDCR produces a selection signal in accordance with an internal, or external address, an erasing operation can be effected in a unit of a data line. Accordingly, the control of the address decoder YDCR of EEPROM is different from the embodiment shown in Fig. 7 during the erasing operation. For description of portions which are the same as that shown in Fig. 7, reference should be made to the description of Fig. 7 set forth above.

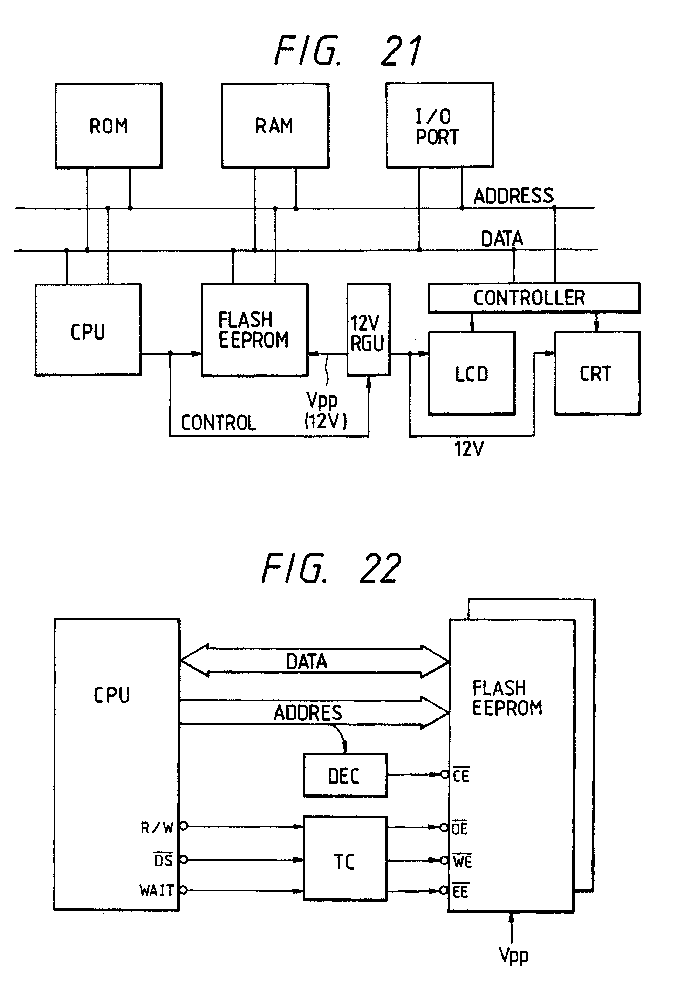

In Fig. 21, there is shown a block diagram of a microcomputer system employing a flash type EEPROM according to the present invention.

In the microcomputer system according to an embodiment of the present invention, there is included: a ROM (read only memory) for storing a program and the like, a RAM (random access memory) employed as a main memory device, and an input/output port I/O PORT, the above-described flash type EEPROM according to the present invention is interconnected to a microprocessor CPU which has a predetermined information processing function, and either a LCD (liquid crystal display device) or a CRT (cathode ray tube) connected via a control circuit CONTROLLER as a monitor via a control bus for transferring a control signal CONTROL to an address bus ADDRESS and a data bus DATA.

The components except for the LCD and CRT can be formed on one semiconductor chip.

In accordance with this embodiment, a 12V power supply RGU required for the above described display device LCD and CRT may be utilized as the high voltage $V_{PP}$ for the flash type EEPROM. As a consequence, such a changing function is additionally provided with this power supply RGU that in response to a control signal from the microprocessor CPU, the terminal $V_{PP}$ is changed into $V_{CC}$, such as 5V, during the read out operation. In Fig. 22, there is shown a connecting relationship diagram with respect to various signals between the microprocessor CPU and EEPROM.

At a chip enable terminal $\overline{CE}$ of the EEPROM, a chip enable signal $\overline{CE}$ is generated by supplying an address signal indicative of an address domain which has been allocated to the EEPROM among a system address, to a decoder circuit DEC. A timing control circuit TC produces an output enable signal $\overline{OE}$, a write enable signal $\overline{WE}$, and an erase enable signal $\overline{EE}$ in response to a R/W (read/write) signal, a $\overline{DS}$ (data strobe) signal and a WAIT signal. It should be noted that a data terminal of the microprocessor CPU is coupled via a data bus to the external input/output terminals $I/O_0$ to $I/O_7$ of the EEPROM, whereas an address terminal of the microprocessor CPU is coupled via an address bus to the external address terminals AX and AY of EEPROM.

Although the external high voltage $V_{PP}$ has been used for writing/erasing in the embodiments shown above, the present invention is not limited thereto. Provided the current flowing at the time of writing/erasing is small, for instance, a desired high voltage may be generated from Vcc within the device and used for writing/erasing. Further, an internal step-up power supply may simultaneously be used with the external high voltage Vpp.

The present invention is not limited to the embodiments described above and the circuit arrangement intended for normal writing/reading and the like may be configured freely on condition that the principle above is realizable.

As set forth above, in the semiconductor nonvolatile memory device capable of making the contents of the memory cell, as small in scale as an EPROM, electrically erased according to the present invention, it is made unnecessary to write data bitwise on a data line basis as before when a decision is made on whether there exists a memory cell whose threshold voltage is negative. The test time can be extremely shortened dramatically.

## Claims

1. A semiconductor memory device comprising:
a memory array comprising a plurality of electrically erasable nonvolatile memory elements arranged in a matrix, each memory element being selected by a single word line and a single data line, wherein a gate of said memory element is connected to said word line and a drain of said memory element is connected to said data line;
a first circuit reading out information stored in said memory element; and
a second circuit grounding the gates of all said memory elements of said memory array during read operation of said memory device.

2. A semiconductor memory device according to claim 1, wherein said second circuit grounds said gates in response to an external signal.

3. A semiconductor memory device according to claim 2, wherein said external signal is a signal which specifies a depletion test.

4. A semiconductor memory device comprising:
a memory array comprising a plurality of electrically erasable nonvolatile memory elements arranged in a matrix and a plurality of word lines, each memory element being selected by one of said word lines and a single data line, gate of said memory element is connected to said word line and drain of said memory element is connected to said data line,
sensing circuit reading out information stored in said memory element; and
an address decoder specifying one word line in response to an address signal in a first mode, and for grounding all word lines regardless of said address signal in a second mode, wherein said sensing circuit is operable in both said first and second modes.

5. A semiconductor memory device according to claim 4, wherein in said first mode the memory device is in one of either a write mode or a read mode, and in said second mode the memory device is in one of either an erase mode or a depletion test mode.

6. A semiconductor memory device comprising:
a memory array comprising a plurality of electrically erasable nonvolatile memory elements arranged in a matrix, each memory element having a gate and being selected by a single word line and a single data line; and
means for reading out the information stored in said memory element while keeping gates of all of said memory elements at a same predetermined voltage.

7. A semiconductor memory device according to claim 6, wherein said predetermined voltage is a voltage placing said memory elements in a nonselected state.

8. A semiconductor memory device according to claim 6, wherein said predetermined voltage is 0 V.

9. A microcomputer comprising:
a CPU having a predetermined information processing function;
a nonvolatile memory device; and
a system bus for connecting said nonvolatile memory device to said CPU;
said nonvolatile memory device comprising:
a memory array comprising a plurality of electrically erasable nonvolatile memory elements arranged in a matrix, each memory element having a gate and being selected by a single word line and a single data line; and
means for reading out the information stored in said memory element while keeping gates of all of said memory elements on the same predetermined voltage.

10. A microcomputer according to claim 9, wherein said predetermined voltage is a voltage placing said memory elements in a non-selected state.

11. A microcomputer according to claim 9, wherein said predetermined voltage is 0 V.

FIG. 1

FIG. 2

FIG. 3

# FIG. 4

FIG. 5(a)

FIG. 5(b)

FIG. 6

EP 0 413 347 A2

FIG. 7

# FIG. 8(a)

# FIG. 8(b)

# FIG. 8(c)

# FIG. 8(d)

FIG. 8(e)

FIG. 8(f)

FIG. 8(g)

FIG. 8(h)

FIG. 8(i)

FIG. 8(j)

# FIG. 9(a)

# FIG. 9(b)

# FIG. 9(c)

## FIG. 10

Vpp

Vcc  Vpp    Vpp

EP ▷ ───▷○───▷○──────── TO Q17

────▷○───▷○──── TO Q10

## FIG. 11(a)

S0~S6    Vcc

$\overline{DO}$ ───

DO ───

I/O
0~6

## FIG. 11(b)

$\overline{POLM}$

S7 ───

$\overline{ES}$

DP - - -

Vcc

$\overline{DO7}$ ───

DO7 ───

I/O
7

24

FIG. 12

FIG. 13

25

# FIG. 14

# FIG. 15

## FIG. 16

## FIG. 17

## FIG. 18

## FIG. 19

# FIG. 20

## FIG. 21

## FIG. 22

31